# EUROPEAN PATENT SPECIFICATION

(11) **EP 3 393 786 B1**
(45) Date of publication and mention of the grant of the patent: **20.11.2019**
(21) Application number: 17701900.7
(22) Date of filing: 31.01.2017
(51) Int. Cl.: B32B 5/02, B08B 9/08, B32B 27/08, B32B 27/10, B32B 27/16, B32B 27/30, B32B 29/00, B32B 29/06, C23C 14/00, C23C 14/02, C23C 14/20

(54) **METALLIZED SUBSTRATES**
METALLISIERTE SUBSTRATE
SUBSTRATS MÉTALLISÉS

(30) Priority: 11.02.2016 NL 2016254
(43) Date of publication of application: 31.10.2018
(73) Proprietor: AR Metallizing N.V., 3600 Genk (BE)
(72) Inventor: GUNDLACH, Kurt, Warren, Massachusetts 01083-1944 (US); MONDELLI, Daniela, 10139 Torino (IT)
(74) Representative: Office Kirkpatrick
(86) International application number: PCT/EP2017/052055
(87) International publication number: WO 2017/137280

(56) References cited:
- EP-A1- 2 292 429
- EP-A2- 2 055 474
- WO-A1-97/35292
- WO-A2-2008/039658
- US-A1- 2006 251 891
- US-A1- 2010 104 844

## Description

### Field of the Invention

The present invention relates to metallized substrates, for example non-woven sheet materials such as paper of the type used as bottle labels.

### Background of the Invention

Metallization of woven or non-woven materials, such as textiles, paper, foils or other sheet-like material in a high vacuum metallization chamber is a well known process. These materials often serve as basis for further printing, e.g. for labels or decorative packaging. Aluminium is the metal of choice for preparing metallized labels as it creates a brilliant, metallic surface and so enhances the aesthetic appeal of the label or decorative packaging. The metallic layer is often overprinted with a print primer layer before being further embellished through overprinting with indicia or designs.

One application of metallized labels is in the beverage bottle industry, particularly glass bottles which can be returned to the beverage producer or distributor where they are cleaned, sterilised and reused. As part of this process, the bottles are subjected to washing step, usually in a caustic (aqueous sodium hydroxide) wash, in order to remove the bottle label or labels, along with any other residue prior to sterilisation and refilling.

However, these aluminium-based labels are known to have poor ink retention during the caustic wash resulting in delamination of the label and contamination of the caustic wash with the ink. Previous solutions to the problem of poor ink retention have been to reduce the amount of metallic aluminium present in the label, or to manufacture the label with multiple layers of protective lacquer. However, less aluminium results in an aesthetically less pleasing finish, while multiple layers of lacquer can render a label so impermeable that the label is no longer easily removed from a bottle during the caustic wash.

In order for the wash step to be as efficient as possible, it is desirable that the washing step be as quick as possible, for example in the order of tens of seconds. It is also desirable that the labels are removed from the bottles as intact as possible to facilitate easy removal from the caustic bath and avoid contamination of the caustic solution with delaminated ink debris.

WO 97/35292 A1 discloses a label, a container comprising said label, and a method for washing such a container with water or an alkaline solution in order to remove the label from the container.

### Summary of the Invention

The invention is defined by the appended claims 1 to 15.

According to a first aspect of the invention, there is provided a method of making a metallized substrate, comprising:
depositing on a base layer an intermediate layer of polymeric material, said base layer being a sheet-like non-woven cellulosic material or comprises fibrous material being tissue, paper or cardboard;
depositing on the intermediate layer by vacuum deposition a metallic layer comprising one or more of tin, nickel or zinc; and
depositing on the metallic layer a top coat of polymeric material.

The present invention is based on the unexpected finding that metallized labels comprising metals other than aluminium as majority component, in particular tin, nickel and zinc, are much more resilient to a caustic wash than the aluminium-based labels. The use of these metals in such labels results in the label retaining more ink than the corresponding labels comprising aluminium. As a result, less ink is leached out of the labels into the caustic bath, meaning that the caustic solution can be reused more times and replenished less often.

It has long been observed that the metallic layer of aluminium based labels react with the heated sodium hydroxide solution to liberate hydrogen gas below the print primer layer with concomitant disintegration of the metallic layer. It was hypothesized that this reduced adhesion of the inked print primer to the underlying substrate as the hydrogen gas permeates through the print primer coating and retentive ink layer, results in the observed ink retention reductions.

The present inventors have unexpectedly found that certain metals, in particular tin and zinc, still provide the brilliant metallic finish to the substrate on which they are deposited, and thus have the same aesthetic appeal as a metallized substrate comprising aluminium, but have significantly increased ink retentive properties. Such a finding could not have been predicted, as tin and zinc are known to react with hot sodium hydroxide and so metallized labels comprising these metals would be predicted to also have poor ink retention. In addition, nickel, like copper and indium, will not react with aqueous sodium hydroxide. The present inventors have however unexpectedly found that unlike copper and indium, which gave poor ink retention, nickel results in high ink retention, similar to tin and zinc, which could not have been predicted based on the metals reactivity with sodium hydroxide.

According to a second aspect of the invention there is provided a metallized substrate, comprising:
a base layer, said base layer being a sheet-like non-woven cellulosic material or comprising fibrous material being tissue, paper or cardboard;
an intermediate layer of polymeric material disposed on the base layer;
a metallic layer comprising one or more of tin, nickel or zinc disposed on the base layer; and
a polymeric top coat disposed on the metallic layer.

Further aspects of the invention relate to the use of tin, nickel or zinc in labels, the use of a metallized substrate as a label and methods of removing from containers multi-layer labels comprising these metals.

### Brief Description of the Figures

Embodiments of the present invention will no be described, purely by way of example, and with reference to the accompanying Figures, in which:
Figure 1a shows metallized substrates comprising tin (left hand side), nickel (centre) and aluminium (right hand side) before treatment with caustic soda;
Figure 1b shows metallized substrates comprising aluminium (samples marked as 13; left hand side) and tin (samples marked as 14; right hand side) after treatment with caustic soda;
Figure 2a shows metallized substrates comprising nickel (left hand side) and aluminium (right hand side) before treatment with caustic soda (disc regions indicate portions removed for treatment);
Figure 2b shows metallized substrates comprising nickel (top row) and aluminium (bottom row) after treatment with caustic soda;
Figure 3 shows metallized substrates comprising copper before (background) and after (overlaid discs) treatment with caustic soda;
Figure 4 shows metallized substrates comprising zinc before (background) and after (overlaid disc) treatment with caustic soda;
Figure 5 shows metallized and printed substrates comprising aluminium after treatment with caustic soda in an ink retention test;
Figure 6 shows metallized and printed substrates comprising tin after treatment with caustic soda in an ink retention test;
Figure 7 shows metallized and printed substrates comprising nickel after treatment with caustic soda in an ink retention test;
Figure 8 shows metallized and printed substrates comprising copper after treatment with caustic soda in an ink retention test;
Figure 9 shows metallized and printed substrates comprising zinc after treatment with caustic soda in an ink retention test; and
Figure 10 shows metallized and printed substrates comprising indium after treatment with caustic soda in an ink retention test.

### Detailed Description of the Invention

Before the present invention is disclosed and described, it is to be understood that this disclosure is not limited to the particular method steps and materials disclosed herein because such method steps and materials may vary somewhat. It is also to be understood that the terminology used herein is used for the purpose of describing particular embodiments. The terms are not intended to be limiting because the scope is intended to be limited by the appended claims and equivalents thereof.

It is noted that, as used in this specification and the appended claims, the singular forms "a," "an," and "the" include plural referents unless the context clearly dictates otherwise.

As used herein, the term "about" is used to provide flexibility to a numerical range endpoint by providing that a given value may be a little above or a little below the endpoint to allow for variation in test methods or apparatus. The degree of flexibility of this term can be dictated by the particular variable and would be within the knowledge of those skilled in the art to determine based on experience and the associated description herein.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary.

Concentrations, amounts, and other numerical data may be expressed or presented herein in a range format. It is to be understood that such a range format is used merely for convenience and brevity and thus should be interpreted flexibly to include not just the numerical values explicitly recited as the limits of the range, but also to include all the individual numerical values or sub-ranges encompassed within that range as if each numerical value and sub-range is explicitly recited. As an illustration, a numerical range of "about 1 wt% to about 5 wt%" should be interpreted to include not just the explicitly recited values of about 1 wt% to about 5 wt%, but also include individual values and subranges within the indicated range. Thus, included in this numerical range are individual values such as 2, 3.5, and 4 and sub-ranges such as from 1-3, from 2-4, and from 3-5, etc. This same principle applies to ranges reciting a single numerical value. Furthermore, such an interpretation should apply regardless of the breadth of the range or the characteristics being described.

As used herein, the term "comprising" is to be understood as having the named component, for example the named metallic element, but not to the exclusion of all other components. Thus, references to a metallic layer comprising tin are not to be taken as references to a layer consisting of tin. Instead, this is to be understood as also encompassing, for example, a metallic layer of a tin alloy.

Unless otherwise stated, any feature described herein can be combined with any aspect or any other feature described herein.

### Metallized Substrate

The metallized substrate may be any substrate or material which is intended to have a metallic sheen or lustre. Examples of metallized substrates may include signs, posters or promotional materials, packaging materials, and labels for containers, for example labels for beverage bottles.

The metallized substrate typically comprises a multi-layer material. It will be understood that the number of layers and exact composition of each layer of the multi-layer material may differ depending on the intended application or use of the metallized substrate. By way of example, a metallized substrate comprising: a base layer, an intermediate layer; a metallic layer; a print primer or top coat layer and a layer of printed ink will now be described, with each layer being discussed in turn.

### Base layer

A metallized substrate as described herein comprises a base layer which forms the base on which other layers are deposited. The base layer comprises a sheet-like non-woven material or comprises a fibrous material being tissue, paper or cardboard.

Typical base layers include one-side coated papers, siliconized papers, craft papers as well as uncoated, highly calendered papers. In one example, the base layer is a one-side coated paper, in which the one side is coated with an inorganic material, for example an inorganic pigment such as titanium dioxide, clay or kaolin, often mixed with a polymeric binder, for increasing the sheen of the paper and for sealing of the sheet to increase applied coating hold out.

In the specific example of the metallized substrate being a label for a returnable beverage bottle, suitable commercially available materials include the MK Colerette paper from Munksjö.

### Intermediate layer of polymeric material

In order to provide a suitable surface for metal deposition, an intermediate layer of polymeric material is present on the base layer. This is intended to provide a smooth surface, free of surface imperfections, on which the metal is deposited, thus further improving the aesthetic appearance of the metallized substrate. In some instances, the presence of the intermediate layer can enhance adhesion of the deposited metal to the base layer.

In one example, the intermediate layer of polymeric material comprises an acrylic or acrylate based polymeric material. A suitable example of an acrylate based polymer is Doresco ELFC0022 (from Lubrizol).

In one example, the intermediate layer comprises a thin film of the polymeric material as defined herein, wherein the film is less than 100 µm in thickness, for example less than 90 µm in thickness, less than 80 µm in thickness, less than 70 µm in thickness, less than 60 µm in thickness, less than 50 µm in thickness, less than 40 µm in thickness, less than 30 µm in thickness, less than 20 µm in thickness, less than 15 µm in thickness, less than 10 µm in thickness, less than 5 µm in thickness, less than 4 µm in thickness, less than 3 µm in thickness, less than 2 µm in thickness. In one example, the film of material is less than or about 1 µm in thickness.

In one example, the intermediate layer comprises a thin film of the polymeric material as defined herein, wherein the film is greater than 1 µm in thickness, greater than 2 µm in thickness, greater than 3 µm in thickness, greater than 4 µm in thickness, greater than 5 µm in thickness, greater than 10 µm in thickness, for example greater than 15 µm in thickness, greater than 20 µm in thickness, greater than 30 µm in thickness, greater than 40 µm in thickness, greater than 50 µm in thickness, greater than 60 µm in thickness, greater than 70 µm in thickness, greater than 80 µm in thickness, greater than 90 µm in thickness. In one example, the film of material is about 100 µm in thickness.

### Metallic layer

An intermediate layer of polymeric material deposited on a base layer is provided with a thin layer comprising one or more of tin, nickel or zinc. In one example, the metallic layer comprises tin or an alloy thereof. In another example, the metallic layer consists of tin. In an alternative example, the metallic layer comprises nickel or an alloy thereof. In another example, the metallic layer consists of nickel. In an alternative example, the metallic layer comprises zinc or an alloy thereof. In another example, the metallic layer consists of zinc.

In another example, the metallic layer comprises or consists of a solder alloy of tin with one or more of silver, copper or bismuth. In one example, the metal wire used to deposit the solder alloy of tin comprises one or more of silver, copper or bismuth in an amount of at least 1%, for example at least 2%, for example at least 3%, for example at least 4%, for example at least 5%, for example up to about 10%. Inclusion of these metals has been shown to harden the metal wire of tin utilized in the vacuum deposition process. In another example, the tin solder alloy may be essentially free from toxic heavy metals such as lead and/or cadmium.

The deposited metal or metal alloy is applied via vacuum deposition, as will be discussed in more detail in the section relating to the method of making the metallized substrate, and adheres to the surface being metallized.

In one example, the metallic layer may have an optical density of at least 1.0, for example at least 1.5, for example at least 2.0, for example at least 2.1, for example at least 2.2, for example at least 2.3, for example at least 2.4, for example at least 2.5, for example at least 2.6, for example at least 2.7, for example at least 2.8, for example at least 2.9, for example at least 3.0, for example at least 3.1, for example at least 3.2, for example at least 3.3, for example at least 3.4, for example at least 3.5, for example at least 4.0, for example at least 4.1, for example at least 4.2, for example at least 4.3, for example at least 4.4, for example at least 4.5, for example at least 4.6, for example at least 4.7.

In one example, the metallic layer may have an optical density of less than 4.7, for example less than 4.6, for example less than 4.5, for example less than 4.4, for example less than 4.3, for example less than 4.2, for example less than 4.1, for example less than 4.0, for example less than 3.5, for example less than 3.4, for example less than 3.3, for example less than 3.2, for example less than 3.1, for example less than 3.0, for example less than 2.9, for example less than 2.8, for example less than 2.7, for example less than 2.6, for example less than 2.5, for example less than 2.4, for example less than 2.3, for example less than 2.2, for example less than 2.1, for example less than 2.0, for example less than 1.5, for example about 1.0.

Measurement of the light transmission of metallic films (i.e. their optical density) is a way of accurately controlling the coating thickness and uniformity, and is routinely carried out in the packaging industry.

In one example, the metallic layer may have a thickness of at least 100 Angstroms, for example at least 200 Angstroms, for example at least 300 Angstroms, for example at least 500 Angstroms. In one example, the metallic layer has a thickness of less than about 500 Angstroms, for example less than about 300 Angstroms, for example less than about 200 Angstroms, for example about 100 Angstroms.

In other examples, the metallic layer may have a thickness of at least 10 nm, for example at least 20 nm, for example at least 30 nm, for example at least 40 nm, for example at least 50 nm, for example at least 100 nm, for example at least 150 nm, for example about 200 nm. In other examples, the metallic layer may have a thickness of less than 200 nm, for example less than 150 nm, for example less than 100 nm, for example less than 50 nm, for example less than 40 nm, for example less than 30 nm, for example less than 20 nm, for example about 10 nm.

The metallic layer is primarily a decorative layer, since it creates a brilliant metallic surface. Print primer coats may be applied to the surface of the metallic layer to enhance its printability, and the metallic layer may also be overprinted with indicia or designs. In one example, the metallic layer is also etched or engraved to reveal the underlying base layer and/or intermediate layer as part of a brand or design.

The metal to be used as the metallic layer should be selected on the basis of at least the following criteria. Firstly, and as mentioned above, the metallic layer is primarily a decorative layer and, as such, the metal may be one which retains a brilliant, shiny, white metallic lustre even when present as a thin film of micron or sub-micron thickness. However, the metal should also be one which is readily atomised in a vacuum deposition process for ease of deposition. A particularly preferred example of a metal which fulfils these criteria is tin, which unexpectedly exhibits high ink retention, though nickel and zinc are also useful in preparing metallized labels and also unexpectedly exhibit high ink retention.

### Top coat/ Print primer coat

In order to protect the metallic layer from oxidation or physical damage as well as improve ink receptivity and colour quality, a top coat or print primer coating is present on top of the metallic layer. The top coat is also referred to as a print primer coating as it also provides a surface which is suitable to receive a printed ink layer.

The top coat comprises a polymeric material, for example an acrylic or acrylate based polymeric material. A suitable example of an acrylate based polymer is Doresco ELFC0022 (from Lubrizol).

In one example, the top coat comprises a thin film of the polymeric material as defined herein, wherein the film is less than 100 µm in thickness, for example less than 90 µm in thickness, less than 80 µm in thickness, less than 70 µm in thickness, less than 60 µm in thickness, less than 50 µm in thickness, less than 40 µm in thickness, less than 30 µm in thickness, less than 20 µm in thickness, less than 15 µm in thickness, less than 10 µm in thickness, less than 5 µm in thickness, less than 4 µm in thickness, less than 3 µm in thickness, less than 2 µm in thickness. In one example, the film of material is less than or about 1 µm in thickness.

In one example, the top coat comprises a thin film of the polymeric material as defined herein, wherein the film is greater than 1 µm in thickness, greater than 2 µm in thickness, greater than 3 µm in thickness, greater than 4 µm in thickness, greater than 5 µm in thickness, greater than 10 µm in thickness, for example greater than 15 µm in thickness, greater than 20 µm in thickness, greater than 30 µm in thickness, greater than 40 µm in thickness, greater than 50 µm in thickness, greater than 60 µm in thickness, greater than 70 µm in thickness, greater than 80 µm in thickness, greater than 90 µm in thickness. In one example, the film of material is about 100 µm in thickness.

### Printed ink layer

The metallized substrate may also be provided with a layer of printed ink, either directly on the metallic layer or more usually on the top coat layer which protects the metallic layer. The layer of printed ink may take the form of pigment particles bound to particles of a resinous material, and be printed in such a way as to depict, for example, a graphic design or indicia to denote the origin of the goods or services inside the container to which the metallized substrate is applied. The printed image may alternatively provide a consumer with regulatory information, health information or other information relating to the product.

### Method of making metallized substrate

A method of making the metallized substrate discussed above will now be described. Prior to deposition of any material, the base layer, for example a fibrous non-woven sheet, may undergo one or more pre-treatment steps. Such pre-treatment steps may include deposition of a layer of inorganic material (for example a white pigmented inorganic material such as clay, kaolin or titanium dioxide), often mixed with a polymeric binder, for increasing the sheen of the paper and for sealing of the sheet to increase applied coating hold out. For the avoidance of doubt, the term base layer includes within its definition a base layer as hereinbefore described (for example a fibrous non-woven material) which has been pre-treated with deposition of the layer of inorganic pigmented material.

The polymeric material which is used as an intermediate layer disposed between the base layer and the layer of metal may be deposited onto the base layer by any known means.

The term "deposition" (or other forms, including "deposited"), is to be understood as meaning applying a layer of material to a supporting layer in such a manner that the materials form a structure of defined layers of different materials. In one example, the depositing comprises one or more of spin-coating, direct gravure coating, offset gravure coating, screen printing, flexo printing, slot die coating and metered rod coating. Such processes and machinery for producing such materials are known in the art.

For example, the polymeric material may be dissolved or dispersed in an organic solvent or water, and deposited by rotogravure coating.

In one example, an intermediate layer of polymeric material is deposited onto the base layer, with the polymeric material being an acrylic based polymeric material. For example, the intermediate layer of polymeric material may comprise a polymer comprising methyl (meth)acrylate, butyl (meth)acrylate, styrene (meth)acrylate or copolymers thereof. The acrylic based polymeric material may be deposited as a dispersion of particles of the polymer in a solvent such as ethyl acetate.

The polymeric material may be present in the dispersion with a solids content of at least 15 wt.% (by volume) of the dispersion, for example at least 20 wt.% (by volume), for example at least 25 wt.% (by volume), for example at least 30 wt.% (by volume). In one example, the polymeric material is present in the dispersion with a solids content of less than 70 wt.% (by volume), for example less than 65 wt.% (by volume), for example less than 60 wt.% (by volume), for example less than 50 wt.% (by volume), for example about 45 wt.% (by volume) of the dispersion.

In the example in which the polymeric material is deposited as a dissolved molecular solution in a liquid medium, the base layer comprising the deposited polymeric material may undergo a drying step for sufficient time at a sufficient temperature to remove the liquid medium. For example, when the liquid medium used is ethyl acetate, drying for one minute at a temperature of 70 °C may be sufficient. The polymeric material may be applied as a water-based acrylic emulsion liquid coating which undergoes a drying step at a sufficient time and a sufficient temperature to remove the water and coalesce the film forming acrylic polymer(s).

In an alternative example, an intermediate layer of polymeric material may be pre-formed as a thin film and laminated to the base layer. In a further example, an intermediate layer of polymeric material may be melt-extruded onto the base layer. Suitable laminating or extrusion equipment is known in the art.

Once the base layer and intermediate layer have been prepared for metallization, a layer of metal, for example tin is deposited by vacuum deposition. Methods of depositing metals using vacuum deposition are known in the art, and involve placing the metal to be deposited, for example a coil of tin wire, into a vacuum chamber with the substrate to be metallized, and subjecting the chamber to a vacuum, with for example sufficient heating to atomise or vaporise the metal, which then condenses on the target (the substrate) to form a thin film. The step of vacuum deposition of the metal may be carried out once, or a number of times, for example two or three times, or until such a time as a desired thickness of metal film is obtained.

In the examples in which the metallic layer comprises an alloy of, for example, tin, the metallic layer may be prepared by evaporation of the separate component metals or of a preformed alloy of the required composition.

The metallized layer may undergo a corona and or plasma treatments to prepare it for deposition of subsequent layers. Such treatments are known in the art.

Following metallization and any subsequent corona and or plasma treatments, a print primer coating or top coat is deposited onto the metallic layer. In one example, the print primer coating or top coat comprises an acrylic based polymeric material.

The polymeric material which forms the top coat may be dissolved or dispersed in an organic solvent or water, and deposited by rotogravure coating.

In one example, a top coat of polymeric material is deposited onto the metallic layer, the polymeric material being an acrylic based polymeric material. For example, the top coat of polymeric material may comprise a polymer comprising methyl (meth)acrylate, butyl (meth)acrylate, styrene (meth)acrylate or copolymers thereof. The acrylic based polymeric material may be deposited as a molecular solution of the polymer dissolved in a solvent such as ethyl acetate or as a particle emulsion or dispersion in a solvent such as water.

The polymeric material may be present in the solution with a solids content of at least 15 wt.% (by volume) of the dispersion, for example at least 20 wt.% (by volume), for example at least 25 wt.% (by volume), for example at least 30 wt.% (by volume). In one example, the polymeric material is present in the dispersion with a solids content of less than 70 wt.% (by volume), for example less than 65 wt.% (by volume), for example less than 60 wt.% (by volume), for example less than 50 wt.% (by volume), for example about 45 wt.% (by volume) of the dispersion.

In the example in which the polymeric material is deposited as a dispersion in a liquid medium, the metallized substrate comprising the deposited polymeric material on the metallic layer may undergo a drying step for sufficient time at a sufficient temperature to remove the liquid medium. For example, when the liquid medium used is ethyl acetate, drying for one minute at a temperature of 70 °C may be sufficient for small scale laboratory purposes. At industrial level, the drying temperature and dwell time may be readily determined by those skilled in the art, and will depend at least in part on the temperature and speed of the particular coating machine used.

In an alternative example, a top coat of polymeric material may be pre-formed as a thin film and laminated to the metallic layer. In a further example, a top coat layer of polymeric material may be melt-extruded onto the metallic layer. Suitable laminating or extrusion equipment is known in the art.

The top coat may also be overprinted with indicia or designs or may be selectively removed, optionally along with selective removal of the metallic layer to create such designs or indicia.

Metallized substrates such as those described herein are particularly used as labels on containers, for example beverage bottles. Accordingly, the method described may further comprise cutting the overprinted substrate to form labels.

The method may also comprise the step of applying an adhesive composition, for example a casein glue, or a pressure-sensitive adhesive composition, to the non-metallized surface of the base layer of the label. The ability to quickly remove the labels from bottles for reuse can be achieved through the use of such adhesives.

Accordingly, the method may also comprise affixing the label to a beverage bottle.

Alternatively, the metallized product may be laminated to heavier board or backing material, depending on the intended use, before or after printing of a design.

### Method of removing multi-layer label from container

A further aspect of the invention relates to a method of removing a multi-layer label from a container.

In this aspect, the method comprises subjecting the container to a sodium hydroxide treatment; wherein the multi-layer label is adhered to the surface of the container and comprises a base layer, an intermediate layer of polymeric material disposed on the base layer, a metallic layer comprising one or more of tin, nickel or zinc disposed on the intermediate layer, a polymeric top coat disposed on the metallic layer, and a layer of printed ink on the polymeric top coat; and removing the label from the container.

The multi-layer label may comprise a metallized substrate as hereinbefore described. The container to which the label is affixed may be a returnable beverage bottle.

The sodium hydroxide treatment may comprise immersion of the container in a solution of aqueous sodium hydroxide. The solution of aqueous sodium hydroxide may be at a temperature of at least 50 °C, for example at least 75 °C. The sodium hydroxide treatment may be for a period of less than 2 minutes, for example less than 1 minute.

The concentration of sodium hydroxide in the aqueous solution may be at least 1 % (w/w), for example at least 2 % (w/w), for example about 2.5 % (w/w).

### Use of tin, nickel or zinc for retaining ink in a label during wash-off

It has been surprisingly found that metallized labels comprising tin, nickel or zinc as metal exhibit a high level of ink retention during wash off of the label from a container. That is, the use of tin, nickel and zinc does not result in delamination of the print primer coating (and the printed retentive ink) from the label and disintegration of the retentive ink in the wash solution.

Instead, the print primer coating and printed ink remain adhered to the label under typical wash conditions, meaning that the label retains its integrity and can be easily fished out from the wash solution. Resultant contamination of the wash solution with the ink is avoided, thus increasing the lifetime of the wash solution, increasing process efficiency and reducing operating costs.

The metals described herein, in particular tin, nickel and zinc therefore find particular use in retaining ink in a label during wash off of the label from a container.

### Examples

The following illustrates examples of the methods and related aspects described herein. Thus, these examples should not be considered as limitations of the present disclosure, but are merely in place to teach how to make and use examples of the present disclosure. As such, a representative number of metallized substrates and their method of manufacture are disclosed herein.

### Materials

Base layer: a 65gsm based paper commercially available as Metalkote Colerette by Munksjo was used.

Polymer for intermediate and print primer layers: Doresco ELFC0022 is an acrylic resin from Lubrizol.

Metals: pure tin was obtained from SRA Soldering Products (Walpole Massachusetts); 20 Nickel 270 annealed wire was obtained from MWS Wire Industries (Westlake Village, California); Zinc etching plate was from obtained from RotoMetals (San Leandro California); bare Copper Wire 16 AWG 66248-029 B16, was obtained from Arcor Northbrook, Illinois 60062; Indium (99.99% pure, 1 ounce) was obtained from RotoMetals (San Leandro, California 94577); and production spools of aluminium were obtained from Manifsa Aluminum Wire-Drawing and Casting, Navarra, Spain.

Retentive printing ink: Yellow and Cyan inks from the Pluricel RC/AE range from Flint Group were used as received.

### Apparatus

Vacuum evaporator: Edwards Auto 306 laboratory bell jar vacuum metallizer
Wire wound metering flood coat draw bars: K Bar wire wound bar coating rods from RK PrintCoat Instruments Ltd., Litlington, Royston, United Kingdom

### General Methodology - polymer deposition for intermediate layer

Metalkote Colerette 65gsm was pre-coated with Lubrizol ELFC0022 by diluting ELFC0022 with ethyl acetate to obtain a solids content of 21% (w/w). This was applied to the base paper substrate on the clay coated side with a direct rotogravure coating process such that the amount of dry varnish deposited onto the paper was around 1.5 g/m². The solvent was evaporated by standard industrial procedure where the paper is passed through heated ovens.

### General Methodology - vacuum deposition of metal

Acrylic polymer coated paper samples were placed polymer side up in the Auto 306 vacuum metallizer with the metal sample placed in the tungsten firing coil. A vacuum was applied to below 2 X 10⁻⁴ mm Hg (torr) prior to applying voltage through the tungsten wire to melt approximately 0.1 - 0.2 g metal wire and then evaporate the metal which deposited on the polymer layer.

### General Methodology - polymer deposition for print primer layer

Samples were prepared by diluting the solution polymer ELFC0022 in ethyl acetate (to a solids content of 21 wt. %) and applying this to the metallized surface with a KCC#2 (12 µm thick liquid coating) wire wound bar followed by oven drying at 70 °C for at least 1 minute to yield 2.5 gsm dried print primer layer.

### General Methodology - printing

Samples were prepared by applying the printing composition above with a KCC#1 wire wound bar (6 µm thick liquid ink) followed by overnight drying at room temperature to yield 2.1 gsm dried retentive ink.

### Test Procedures

Metal OD determination: optical density was measured on a Tobias Associates Inc. Densitometer in accordance with the standard operating instructions. The lower value is the optical density of a metallized region near the edge of the substrate, while the upper value is the optical density of a metallized region in the centre of the substrate. For all subsequent tests, samples were taken from regions in the centre of the metallized substrate.

Gloss: was measured on a BYK Gardner micro-TRI-gloss meter in accordance with the standard operating instructions.

Wash off: Wash off was measured by following the procedure of DIN16524-6 (Version 1996-07). According to this test method the labels are glued to a glass surface by a neutral casein glue. After at least 48 hours drying time the labels are placed in contact with a caustic soda solution (NaOH concentration=1,0%) at 75°C under a 250rpm stirring condition. The amount of time required by the labels to be de-glued from the glass is the wash-off time.

Ink Retention: Ink retention was measured by following the procedure of DIN16524-7 (Version 1996-09). According to this test method labels are submerged in a caustic soda solution (NaOH concentration = 2,5%) at 85°C under 250 rpm stirring conditions, for 20 minutes. After this time the labels are dried at room temperature and the percentage of retentive ink loss is evaluated visually and assigned an ink retention percentage.

Metallized and printed substrates comprising intermediate and print primer layers were prepared according to the general methodologies described above, air dried for 72 hours in the case of off set conventional ink retentive type inked labels or 24 hours for rotogravure ink retentive type inked labels, and tested for ink retention according to the test procedure described above. The degree of ink retention and rub resistance following treatment was evaluated visually.

Samples were also tested for drop off time wash off. Metallized and printed samples were coated on the reverse side of the base layer with a commercially available neutral casein glue (Turmerleim ST 50KF) and tested according to the test procedure above. Results are shown in Table 1 below.

**Table 1**

| Example | 1 | 2 | 3 | Comparative Example 1 | Comparative Example 2 | Comparative Example 3 |
|---|---|---|---|---|---|---|
| Metal | Sn | Ni | Zn | Al | In | Cu |
| Metal OD | 2.0 - 4.5 | 2.1 - 3.6 | 1.3 - 1.5 | 1.4 - 2.4 | 1.6 - 3.7 | 2.5 - 2.8 |
| 60° Gloss | 505 | not recorded | 230 | 574 | 560 | 474 |
| Ink retention | 100% | 100% | 100% | 85% | 70 | 10 |
| Wash off (sec) | 71 | 225 | 80 | 70 | > 600 | > 600 |

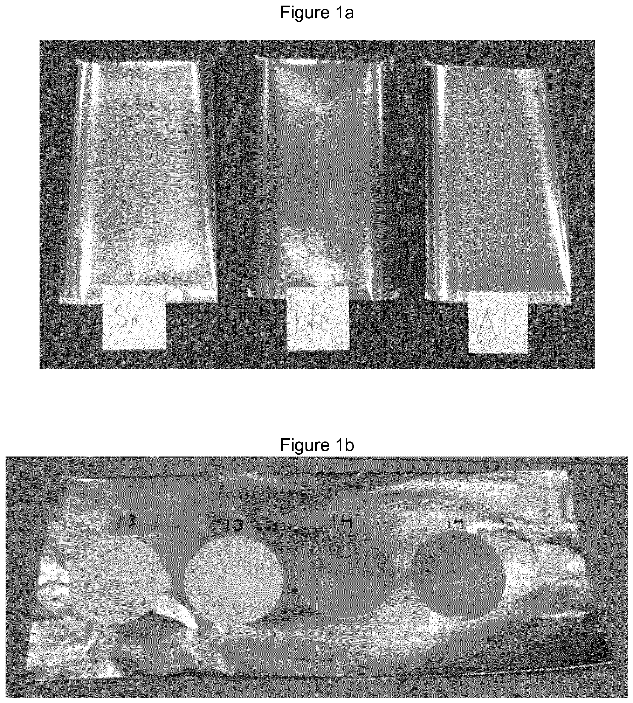

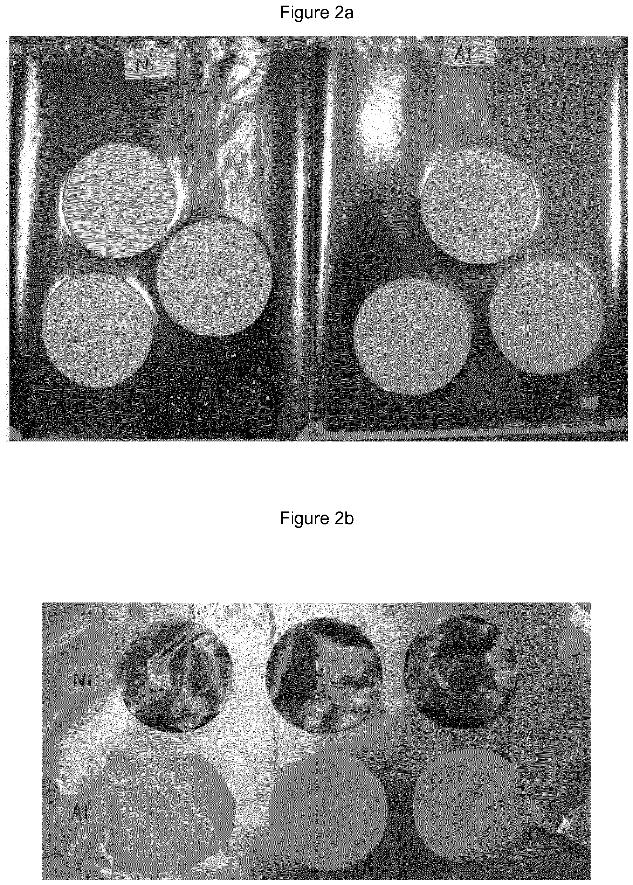

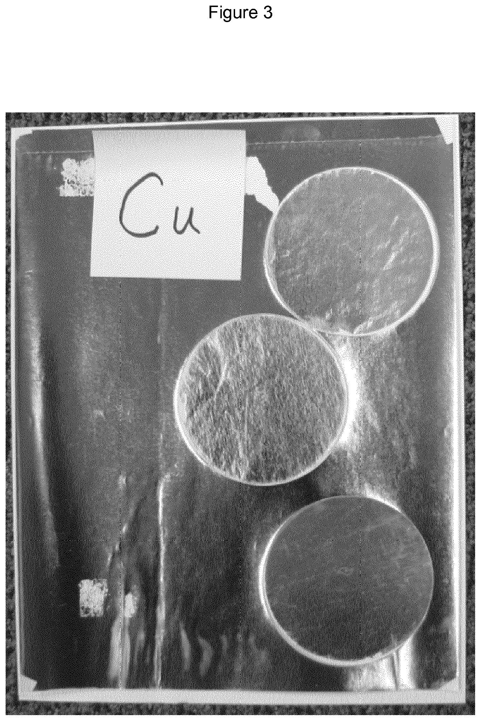

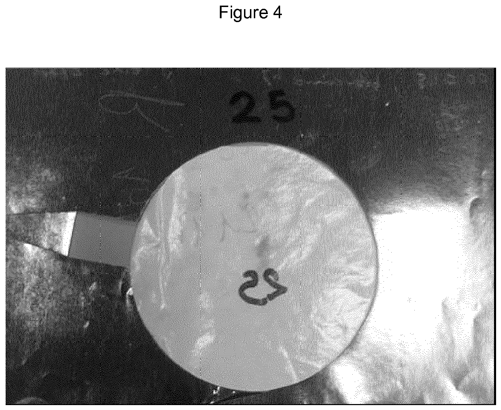

As can be seen in Table 1 and Figures 1 to 5, the metallized labels comprising, nickel, tin and zinc also exhibit much shorter wash off times than the other tested metals, copper and indium, which are unreactive to hot caustic solution and in particular, tin and zinc exhibited wash off times similar to aluminium. Laboratory testing revealed that tin and nickel remained as majority zero valent metal on the label during the caustic wash, whereas aluminium and zinc were fully oxidized within 70 - 80 seconds required for label drop off.

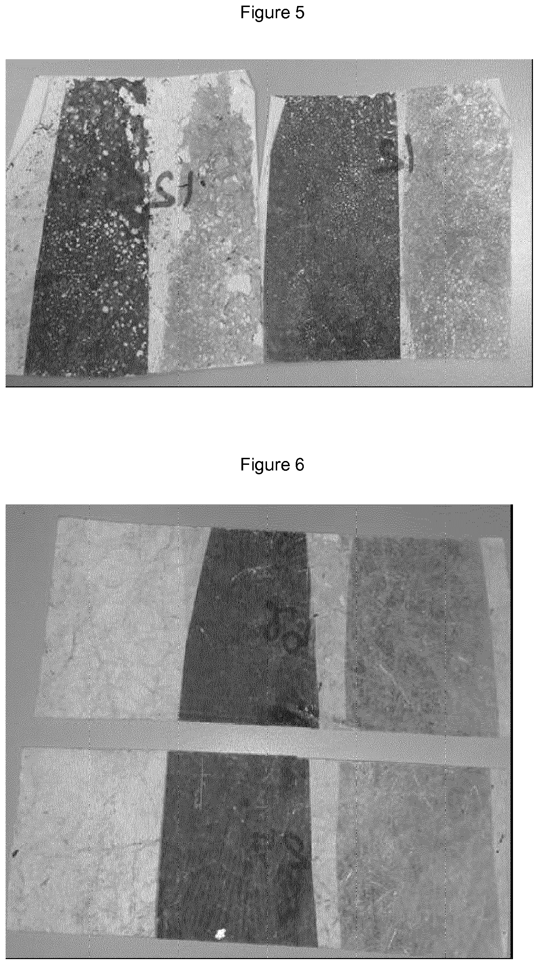

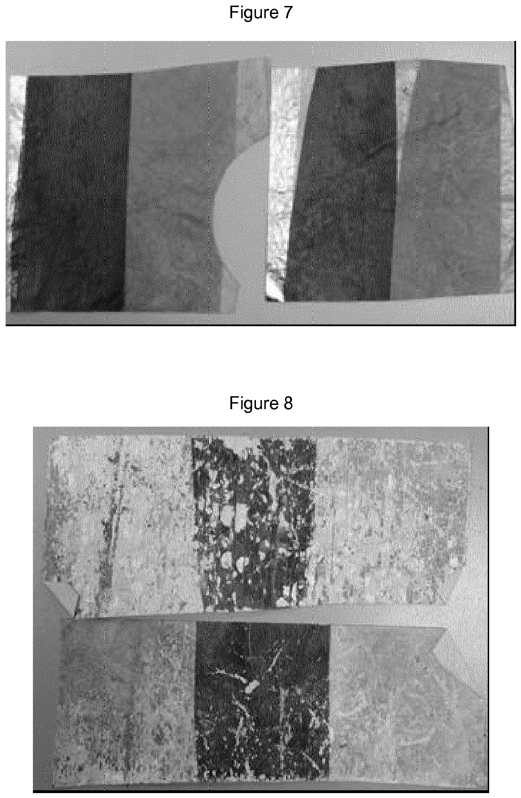

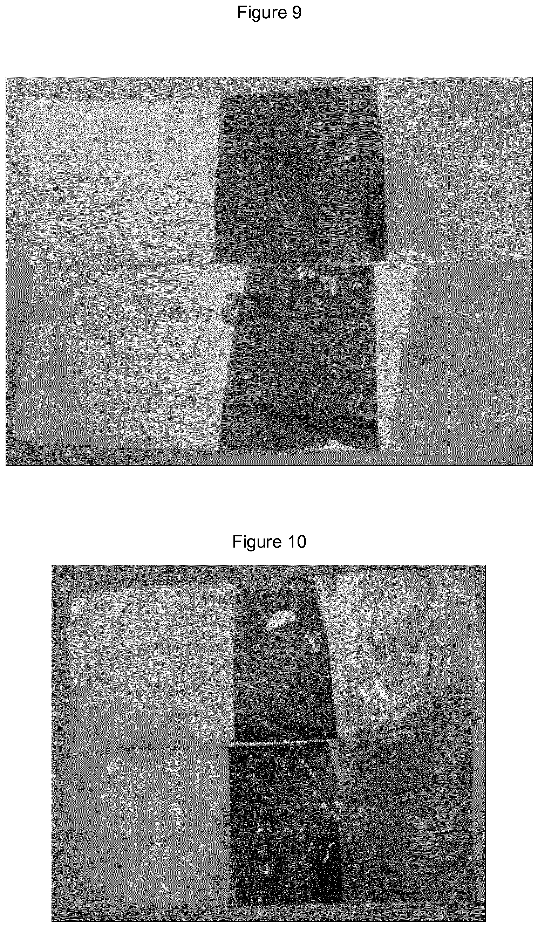

In addition, and as can be seen from Table 1 and Figures 6 to 10, metallized and printed labels comprising tin, nickel or zinc all exhibit 100% ink retention, whereas aluminium (the current industry standard) exhibits a reduction in ink retention, and other metals (indium and copper) which are known not to react with caustic actually exhibit even worse ink retention, which would not have been predicted.

While the present invention has been described with reference to specific preferred embodiments, it should be appreciated that variations are possible without departing from the scope of the invention. Therefore, the invention is not intended to be limited by the description in the specification but only by the language of the claims and equivalents thereof.

## Claims

1. A method of making a metallized substrate suitable for retaining, during caustic wash, retentive ink applied thereto, comprising:
- depositing on a base layer an intermediate layer of polymeric material, said base layer being a sheet-like non-woven cellulosic material or comprises fibrous material being tissue, paper or cardboard;
- depositing on the intermediate layer by vacuum deposition a metallic layer comprising one or more of tin, nickel or zinc; and
- depositing on the metallic layer a top coat of polymeric material.

2. A method according to claim 1, wherein the metallic layer comprises an alloy of one or more of tin, nickel or zinc.

3. A method according to any one of the preceding claims, wherein the top coat and/or the intermediate layer of polymeric material comprises an acrylic-based polymer.

4. A method according to any one of claims 1 to 3, further comprising the step of printing with retentive inks an image or design onto the top coat of polymeric material.

5. A metallized substrate suitable for retaining, during caustic wash, retentive ink applied thereto, comprising:
- a base layer, said base layer being a sheet-like non-woven cellulosic material or comprising fibrous material being tissue, paper or cardboard;
- an intermediate layer of polymeric material disposed on the base layer;
- a metallic layer comprising one or more of tin, nickel or zinc disposed on the base layer; and
- a polymeric top coat disposed on the metallic layer.

6. A metallized substrate according to claim 5, wherein the metallic layer comprises an alloy of one or more of tin, nickel or zinc.

7. A metallized substrate according to claim 5 or claim 6, wherein the polymeric top coat and/or the intermediate polymeric layer comprises an acrylic-based polymer.

8. A metallized substrate according to any one of claims 5 to 7, further comprising a printed image or design on the polymeric top coat.

9. Use of tin, nickel or zinc for retaining retentive inks in a label during caustic wash-off of the label from a container.

10. The use of the metallized substrate of any one of claims 5 to 8 as a label.

11. The use of any one of claims 9 and 10, wherein an alloy of one or more of tin, nickel or zinc is used.

12. A method of removing a multi-layer label from a container, comprising:
- subjecting the container to a sodium hydroxide treatment; wherein the multi-layer label is adhered to the surface of the container and comprises a base layer, an intermediate layer of polymeric material disposed on the base layer, a metallic layer comprising one or more of tin, nickel or zinc disposed on the intermediate layer, a polymeric top coat disposed on the metallic layer, and a layer of printed retentive inks on the polymeric top coat; and
- removing the label from the container.

13. A method according to claim 12, wherein the intermediate layer and/or the polymeric top coat comprises an acrylic- based polymer.

14. A method according to any one of claims 12 to 13, wherein the base layer comprises fibrous material being tissue, cardboard or paper.

15. A method according to any one of claims 12 to 14, wherein the multilayer label is affixed to the container with an adhesive composition.

## Patentansprüche

1. Verfahren zum Herstellen eines metallisierten Substrats, das geeignet ist, um beständige Tinte, die darauf aufgebracht ist, während kaustischen Waschens beizubehalten, umfassend:
- Auftragen, auf einer Basisschicht, einer Zwischenschicht aus Polymermaterial, wobei die Basisschicht ein blattartiges nichtgewobenes cellulosehaltiges Material ist oder faserförmiges Material umfasst, das Stoff, Papier oder Karton ist;
- Auftragen, auf der Zwischenschicht durch Vakuumabedampfen, einer metallischen Schicht, umfassend eines oder mehrere von Zinn, Nickel oder Zink; und
- Auftragen, auf der metallischen Schicht, einer obersten Beschichtung aus Polymermaterial.

2. Verfahren nach Anspruch 1, wobei die metallische Schicht eine Legierung von einem oder mehreren von Zinn, Nickel oder Zink umfasst.

3. Verfahren nach einem der vorstehenden Ansprüche, wobei die oberste Beschichtung und/oder die Zwischenschicht aus Polymermaterial ein acrylbasiertes Polymer umfasst.

4. Verfahren nach einem Ansprüche 1 bis 3, weiter umfassend den Schritt des Druckens, mit beständiger Tinten, eines Bildes oder Designs auf die oberste Beschichtung aus Polymermaterial.

5. Metallisiertes Substrat, das geeignet ist, um beständige Tinte, die darauf aufgebracht ist, während kaustischen Waschens beizubehalten, umfassend:
- eine Basisschicht, wobei die Basisschicht ein blattartiges nichtgewobenes cellulosehaltiges Material ist oder faserförmiges Material umfasst, das Stoff, Papier oder Karton ist;
- eine Zwischenschicht aus Polymermaterial, die auf der Basisschicht aufgetragen ist;
- eine metallische Schicht, umfassend eines oder mehrere von Zinn, Nickel oder Zink, auf der Basisschicht aufgetragen; und
- eine polymere oberste Beschichtung, die auf der metallischen Schicht aufgetragen ist.

6. Metallisiertes Substrat nach Anspruch 5, wobei die metallische Schicht eine Legierung von einem oder mehreren von Zinn, Nickel oder Zink umfasst.

7. Metallisiertes Substrat nach Anspruch 5 oder Anspruch 6, wobei die polymere oberste Beschichtung und/oder die polymere Zwischenschicht ein acrylbasiertes Polymer umfasst.

8. Metallisiertes Substrat nach einem der Ansprüche 5 bis 7, weiter umfassend ein gedrucktes Bild oder Design auf der polymeren obersten Beschichtung.

9. Verwendung von Zinn, Nickel oder Zink zum Beibehalten von beständiger Tinten in einem Etikett während kaustischen Abwaschens des Etiketts von einem Behälter.

10. Verwendung des metallischen Substrats nach einem der Ansprüche 5 bis 8 als ein Etikett.

11. Verwendung einer der Ansprüche 9 und 10, wobei eine Legierung eines oder mehrerer von Zinn, Nickel oder Zink verwendet wird.

12. Verfahren zum Entfernen eines mehrschichtigen Etiketts von einem Behälter, umfassend:
- Aussetzen des Behälters einer Natriumhydroxidbehandlung; wobei das mehrschichtige Etikett an die Oberfläche des Behälters gehaftet wird und eine Basisschicht, eine Zwischenschicht aus Polymermaterial, die auf der Basisschicht aufgetragen ist, eine metallische Schicht, umfassend eines oder mehrere von Zinn, Nickel oder Zinn, die auf der Zwischenschicht aufgetragen ist, eine polymere oberste Beschichtung, die auf der metallischen Schicht aufgetragen ist, und eine Schicht gedruckter beständiger Tinten auf der polymeren obersten Beschichtung umfasst; und
- Entfernen des Etiketts vom Behälter.

13. Verfahren nach Anspruch 12, wobei die Zwischenschicht und/oder die polymere oberste Beschichtung ein acrylbasiertes Polymer umfasst.

14. Verfahren nach einem der Ansprüche 12 bis 13, wobei die Basisschicht faserförmiges Material umfasst, das Stoff, Karton oder Papier ist.

15. Verfahren nach einem der Ansprüche 12 bis 14, wobei das mehrschichtige Etikett mit einer haftenden Zusammensetzung an den Behälter angebracht ist.

## Revendications

1. Un procédé pour faire un substrat métallisé apte à retenir, pendant un lavage caustique, de l'encre de rétention appliquée sur celui-ci, comprenant :
- déposer sur une couche de base une couche intermédiaire de matériau polymère, ladite couche de base étant un matériau cellulosique non-tissé en forme de feuille ou comprend un matériau fibreux étant du tissu, du papier ou du carton ;
- déposer sur la couche intermédiaire par dépôt sous vide une couche métallique comprenant un ou plusieurs étain, nickel ou zinc ; et
- déposer sur la couche métallique un revêtement supérieur de matériau polymère.

2. Le procédé selon la revendication 1, où la couche métallique comprend un alliage d'un ou plusieurs étain, nickel ou zinc.

3. Le procédé selon l'une des revendications précédentes, où le revêtement supérieur et/ou la couche intermédiaire de matériau polymère comprend un polymère à base d'acrylique.

4. Le procédé selon l'une des revendications des revendications 1 à 3, comprenant en outre l'étape d'impression avec de l'encre de rétention, d'une image ou d'un dessin sur le revêtement supérieur en matériau polymère.

5. Un substrat métallique apte pour retenir, pendant un lavage caustique, de l'encre de rétention appliquée sur celui-ci, comprenant :
- une couche de base, ladite couche de base étant un matériau cellulosique non-tissé en forme de feuille ou comprenant un matériau fibreux étant du tissu, du papier ou du carton ;
- une couche intermédiaire de matériau polymère disposée sur la couche de base ;
- une couche métallique comprenant un ou plusieurs étain, nickel ou zinc disposés sur la couche de base ; et
- un revêtement polymère supérieur disposé sur la couche métallique.

6. Un substrat métallique selon la revendication 5, où la couche métallique comprend un alliage d'un ou plusieurs étain, nickel ou zinc.

7. Un substrat métallique selon la revendication 5 ou 6, où le revêtement supérieur et/ou la couche intermédiaire de polymère comprend un polymère de base acrylique.

8. Un substrat métallique selon l'une des revendications 5 à 7, comprenant en outre une image imprimée ou un dessin sur le revêtement polymère supérieur.

9. Une utilisation d'étain, de nickel ou de zinc pour retenir l'encre de rétention sur une étiquette pendant un lavage caustique de l'étiquette d'un récipient.

10. L'utilisation du substrat métallique de l'une des revendications 5 à 8 comme étiquette.

11. L'utilisation selon l'une des revendications 9 et 10, où un alliage d'un ou plusieurs étain, nickel ou zinc est utilisé.

12. Un procédé pour enlever une étiquette multicouche d'un récipient, comprenant :
- soumettre le récipient à un traitement d'hydroxyde de sodium ; où l'étiquette multicouche est collée à la surface du récipient et comprend une couche de base, une couche intermédiaire de matériau polymère disposée sur la couche de base, une couche métallique comprenant un ou plusieurs étain, nickel ou zinc disposée sur la couche intermédiaire, un revêtement polymère disposé sur la couche métallique, et une couche d'encre de rétention imprimée sur le revêtement polymère supérieur ; et
- enlever l'étiquette du récipient.

13. Le procédé selon la revendication 12, où la couche intermédiaire et/ou le revêtement polymère supérieur comprend un polymère de base acrylique.

14. Le procédé selon la revendication 12 ou 13, où la couche de base comprend des matériaux fibreux étant du tissu, du carton ou du papier.

15. Le procédé selon l'une des revendications 12 à 14, où l'étiquette multicouche est collée sur le récipient à l'aide d'une composition adhésive.
